# EUROPÄISCHE PATENTANMELDUNG

(11) **EP 0 923 081 A2**
(43) Veröffentlichungstag der Anmeldung: **16.06.1999**
(21) Anmeldenummer: 98121742.5
(22) Anmeldetag: 16.11.1998
(51) Int. Cl.: G11C 16/06

(54) **Verfahren zum Beschreiben und/oder Löschen eines flash-EPROMs**

(30) Priorität: 10.12.1997 DE 19754704
(71) Anmelder: ROBERT BOSCH GMBH, 70442 Stuttgart (DE)
(72) Erfinder: Grimm, Wolfgang, 74254 Offenau (DE); Pruellage, Arno, 76187 Karlsruhe (DE)

(57) **Zusammenfassung**

Die Erfindung betrifft ein Verfahren zum Beschreiben und/oder Löschen eines flash-EPROMs, wobei eine Programmier- beziehungsweise Löschspannung einer Lesespannung des flash-EPROMs entspricht, und zum Unterscheiden der Programmier- beziehungsweise Löschspannung von der Lesespannung Programmier- beziehungsweise Löschalgorithmen mit definierten Adressen und definierten Daten in einer definierten Reihenfolge abzuarbeiten sind.

Es ist vorgesehen, daß die Programmier- beziehungsweise Löschalgorithmen in einem flüchtigen Speicher verlagert werden.

## Beschreibung

Die Erfindung betrifft ein Verfahren zum Beschreiben und/oder Löschen eines flash-EPROMs mit den im Oberbegriff des Anspruchs 1 genannten Merkmalen.

### Stand der Technik

Als flash-EPROM (Erasable Programmable Read Only Memory) ausgebildete Halbleiterspeicher sind bekannt. Diese besitzen in einer Matrix angeordnete Speicherzellen, die von ansteuerbaren Transistorschaltungen gebildet werden, die entsprechend eines zu speichernden Dateninhalts in definierte Schaltzustände versetzbar sind. Zum Beschreiben, Überschreiben und/oder Löschen der flash-EPROMs ist bekannt, diese mit einer Programmier- beziehungsweise Löschspannung zu beaufschlagen, wobei entsprechend der gewünschten Abspeicherung definierte Adressen und definierte Daten an die entsprechenden Adress- beziehungsweise Datenleitungen zu geben sind. Beim Einsatz der flash-EPROMs in bestimmten Schaltungsanordnungen, beispielsweise in Steuergeräten von Kraftfahrzeugen, ist es wünschenswert, daß eine Programmier- beziehungsweise Löschspannung der flash-EPROMs einer Lesespannung der flash-EPROMs entspricht, damit kein zusätzliches Spannungspotential bereitzustellen ist. Um das Anliegen einer Programmier- beziehungsweise Löschspannung von der Lesespannung in diesem Fall unterscheiden zu können, ist bekannt, bestimmte Programmier- beziehungsweise Löschalgorithmen zu verwenden, mittels denen ein versehentliches Beschreiben oder Löschen des flash-EPROMs verhindert werden soll. Diese Programmier- beziehungsweise Löschalgorithmen beinhalten eine Bearbeitung einer Routine mit definierten Adressen und definierten Daten. Hierbei wird das flash-EPROM durch eine bestimmte Reihenfolge von Schreibbefehlen auf definierten Adressen und mit definierten Daten angesteuert. Hierbei ist nachteilig, daß infolge zufälliger elektromagnetischer Entladung (EMV), Programmierfehler, Hardwarefehler und/oder Spannungspulse eine zufällige Aktivierung der Programmier- beziehungsweise Löschalgorithmen erfolgen kann, die zu einem ungewollten Überschreiben beziehungsweise Löschen des flash-EPROMs führen können.

### Vorteile der Erfindung

Das erfindungsgemäße Verfahren mit den im Anspruch 1 genannten Merkmalen bietet demgegenüber den Vorteil, daß in einfacher Weise ein unbeabsichtigtes Programmieren beziehungsweise Löschen des flash-EPROMs verhindert werden kann. Dadurch, daß die Programmierbeziehungsweise Löschalgorithmen in einem, dem flash-EPROM logisch zugeordneten, flüchtigen Speicher verlagert werden, wird vorteilhaft erreicht, daß durch zufälliges Beaufschlagen des flash-EPROMs mit einer elektromagnetischen Entladung, Programmierfehler, Hardwarefehler und/oder Spannungspulse, eine versehentliche Überschreibung beziehungsweise Löschung des gespeicherten Inhalts nicht erfolgen kann.

In bevorzugter Ausgestaltung der Erfindung ist vorgesehen, daß die für die Abarbeitung der Programmierbeziehungsweise Löschalgorithmen notwendigen Adressinformationen und Dateninformationen erst durch ein externes Programmiergerät zum Beschreiben beziehungsweise Löschen des flash-EPROMs bereitgestellt werden. Hierdurch wird vorteilhaft erreicht, daß trotz der im flüchtigen Speicher abgelegten Programmier- beziehungsweise Löschalgorithmen dieser ebenfalls nicht durch einen zufälligen Spannungspuls aktivierbar ist, da die zum Beschreiben beziehungsweise Löschen des flash-EPROMs notwendigen Adress- beziehungsweise Dateninformationen nicht enthalten sind. Somit ist der flüchtige Speicher ohne eine exakte Initialisierung über die notwendigen Adressen- und Dateninformationen nicht aktivierbar. Erst wenn durch eine serielle Kommunikation mit dem Programmiergerät von diesem signalisiert wird, daß eine Programmierung, das heißt Beschreibung, Überschreibung oder Löschung des flash-EPROMs erfolgen soll, können die im flüchtigen Speicher abgelegten Programmier- beziehungsweise Löschalgorithmen mit den notwendigen Adressinformationen beziehungsweise Dateninformationen geladen werden. Dieses Laden des flüchtigen Speichers kann vorzugsweise über einen vom Programmiergerät ausführbaren Befehl oder durch unmittelbare Übergabe nach Herstellung der seriellen Verbindung zwischen dem Programmiergerät und einem das flash-EPROM aufweisenden Steuergerät erfolgen.

Insgesamt kann durch das erfindungsgemäße Verfahren sichergestellt werden, daß eine erhöhte Sicherheit der in dem flash-EPROM abgelegten Speicherinformationen gegenüber zufälligem Überschreiben beziehungsweise Löschen, insbesondere infolge von auf EMV-Störung zurückzuführender Spannungspulse, verbessert ist. Dadurch, daß die Programmier- beziehungsweise Löschalgorithmen inaktiv sind und diese vorteilhaft zudem die notwendigen Adress- beziehungsweise Dateninformationen nicht enthalten, kann selbst durch ein mehrmaliges, zum Beispiel durch EMV verursachtes Ausführen der Lösch- beziehungsweise Programmieralgorithmen eine Programmierung beziehungsweise Löschung des flash-EPROMs nicht ausgelöst werden, weil diese Algorithmen nicht initialisiert sind.

Weitere vorteilhafte Ausgestaltungen der Erfindung ergeben sich aus den übrigen, in den Unteransprüchen genannten Merkmalen.

### Zeichnung

Die Erfindung wird nachfolgend in einem Ausführungsbeispiel anhand der zugehörigen Zeichnung, die ein Blockschaltbild des Verfahrens zum Beschreiben und/oder Löschen eines flash-EPROMs zeigt, näher erläutert.

### Beschreibung des Ausführungsbeispiels

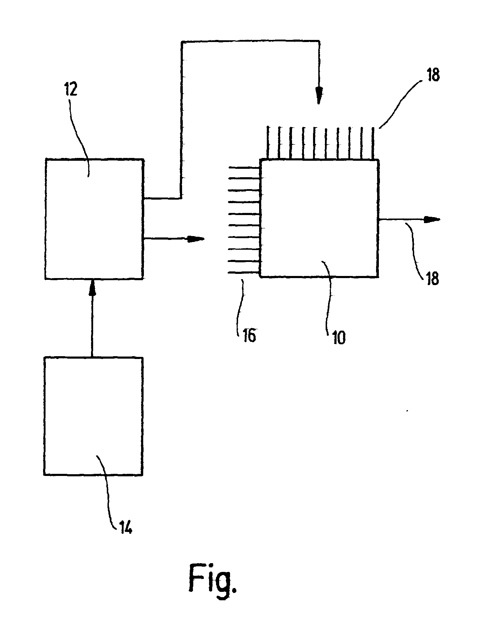

In der Figur ist in einem Blockschaltbild die Verschaltung eines flash-EPROMs 10 mit einem flüchtigen Speicher 12 sowie einem Programmiergerät 14 gezeigt. Der EPROM 10 ist über Daten- beziehungsweise Adressleitungen 16 beziehungsweise 18 entsprechend der Matrixanordnung der Speicherelemente des EPROMs 10 programmierbar. Die Programmierung des EPROMs 10 ist über eine hier lediglich angedeutete Leseverbindung 18 abgreifbar.

Zur Programmierung des EPROMs 10 ist der flüchtige Speicher 12 vorgesehen, in dem ein Programmier- und/oder Löschalgorithmus abgespeichert ist. Entsprechend des Programmier- und/oder Löschalgorithmus können die Daten- und Adressleitungen 16 und 18 in bestimmter Reihenfolge angesteuert werden. Die Auslösung des Programmier- und/oder Löschalgorithmus erfolgt über das Steuergerät 14, das einen entsprechenden Befehl gibt. Bevorzugt ist, wenn das Steuergerät 14 die konkreten Adress- und Datenleitungen 16 beziehungsweise 18 dem flüchtigen Speicher 12 vorgibt, an denen der im flüchtigen Speicher 12 abgelegte Programmier- und/oder Löschalgorithmus durchgeführt werden soll.

## Patentansprüche

1. Verfahren zum Beschreiben und/oder Löschen eines flash-EPROMs, wobei eine Programmier- beziehungsweise Löschspannung einer Lesespannung des flash-EPROMs entspricht, und zum Unterscheiden der Programmierbeziehungsweise Löschspannung von der Lesespannung Programmier- beziehungsweise Löschalgorithmen mit definierten Adressen und definierten Daten in einer definierten Reihenfolge abzuarbeiten sind, **dadurch gekennzeichnet,** daß die Programmier- beziehungsweise Löschalgorithmen in einem flüchtigen Speicher verlagert werden.

2. Verfahren nach Anspruch 1, **dadurch gekennzeichnet,** daß eine Aktivierung des flüchtigen Speichers ausschließlich durch ein externes Programmiergerät erfolgt.

3. Verfahren nach einem der vorhergehenden Ansprüche, **dadurch gekennzeichnet,** daß eine Übergabe der den Programmier- beziehungsweise Löschalgorithmen zugeordneten Adressinformationen und Dateninformationen über das Programmiergerät erfolgt.
